Europäisches Patentamt

European Patent Office

Office européen des brevets

(19)

(11) Veröffentlichungsnummer: **0 351 446 B1**

## (12) EUROPÄISCHE PATENTSCHRIFT

(45) Veröffentlichungstag der Patentschrift: **01.04.92**

(51) Int. Cl.5: **G01N 24/08**

(21) Anmeldenummer: **88111873.1**

(22) Anmeldetag: **22.07.88**

(54) Pulssequenz für ein Kernspin-Tomographiegerät.

(43) Veröffentlichungstag der Anmeldung:
**24.01.90 Patentblatt 90/04**

(45) Bekanntmachung des Hinweises auf die
Patenterteilung:
**01.04.92 Patentblatt 92/14**

(84) Benannte Vertragsstaaten:
**DE GB**

(56) Entgegenhaltungen:
**WO-A-87/00922**
**GB-A- 2 139 764**

**INSTRUMENTATION & EXPERIMENTAL TECH-
NIOUES Band 21, Nr. 1/2, 1978, Seiten
134-136, A.V. ANISIMOV et al .: "Pulsed
magnetic-field gradient program for studying diffusion of absorbed molecules by the
spin-echo method."**

**PATENT ABSTRACTS OF JAPAN Band 10, Nr
12(P-421)(2069), 17 January 1986; & JP-
A-60168042**

**SIEMENS FORSCHUNGS- UND ENTWICK-
LUNGSBERICHTE Band 15, Nr. 1, Seiten 40-48
1986, Berlin, D; A. OPPELT: "Entwicklung und
Erprobung von Funktionsmuster für die
Kernspintomographie."**

**AMERICAN ROENTGEN RAY SOCIETY AJR
143, Dezember 1984, Seiten 1175-1182, San
Fransisco, US; R.L. EHMAN et al.: "Magnetic
Resonance Imaging with Respiratory Gating:
Techniques and Advantages."**

(73) Patentinhaber: **SIEMENS AKTIENGESELL-
SCHAFT
Wittelsbacherplatz 2
W-8000 München 2(DE)**

(72) Erfinder: **Heubes, Peter, Dr. rer. nat.
Sandstrasse 2a
W-8521 Poxdorf(DE)**

**Beschreibung**

Die Erfindung betrifft eine Pulssequenz für ein Kernspin-Tomographiegerät mit Spulen zum Anlegen von magnetischen Grund- und Gradientenfeldern an ein Untersuchungsobjekt und mit einer Hochfrequenzeinrichtung, die das Untersuchungsobjekt mit einer Folge von Hochfrequenzimpulsen bestrahlt und die vom Untersuchungsobjekt ausgesandten Kernresonanzsignale erfaßt, wobei während eines Scans Gradientenfelder wiederholt eingeschaltet werden und wobei die Repetitionszeit der Scans nicht konstant ist.

Dabei wird als "Scan" der Ablauf eines Meßvorganges zur Erstellung einer einzelnen Fourier-Projektion bezeichnet. Aufgrund der Meßwerte mehrerer Scans, die mit einer Repetitionszeit wiederholt werden, erhält man eine Matrix, aus der durch zwei-oder dreidimensionale Fourier-Transformation ein Bild gewonnen wird.

Eine nicht konstante Repetitionszeit bei Pulssequenzen tritt insbesondere dann auf, wenn die Messungen in Abhängigkeit von Bewegungen des Untersuchungsobjektes getriggert werden. Eine solche Triggerung kann z.B. aufgrund der Atmung erfolgen, wie dies z.B. in der EP-A2-0 117 725 oder in dem Artikel "Magnetic Resonance Imaging with a Respiratory Gating", American Röntgen Ray Society, AJR 143: Seiten 1175 - 1182, Dezember 1984 beschrieben ist. Bei Untersuchungen im Bereich des Herzens wird häufig auch eine EKG-Triggerung eingesetzt. Durch eine bewegungsabhängig getriggerte Messung sollen Bewegungsartefakte verhindert werden. Die Repetitionszeit der Scans ist dann allerdings nicht mehr konstant, sondern abhängig von der jeweiligen Bewegung (z.B. Atem oder Herzschlag).

Die fehlende Konstanz der Repetitionszeit führt zu einer Beeinträchtigung der Qualität der MR-Bilder aufgrund von Wirbelströmen, wie im folgenden noch näher erläutert wird.

Aufgabe der vorliegenden Erfindung ist es, eine Pulssequenz der eingangs genannten Art so auszugestalten, daß der Einfluß variierender Repetitionszeiten auf die Wirbelstrombildung nicht zu einer Verringerung der Qualität der erzielten Bilder führt.

Diese Aufgabe wird erfindungsgemäß dadurch gelöst, daß in der Zeit zwischen zwei aufeinanderfolgenden Scans Gradientenpulse mit einem zeitlichen Mittelwert geschaltet werden, der gleich dem zeitlichen Mittelwert der entsprechenden Gradienten während jedes Scans ist.

Vorteilhafte Ausgestaltungen der Erfindung sind in den Unteransprüchen angegeben.

Ein Ausführungsbeispiel der Erfindung wird nachfolgend anhand der FIG 1 bis 9 näher erläutert. Dabei zeigt

FIG 1     den schematischen Aufbau eines Kernspin-Tomographiegerätes,

FIG 2     ein Beispiel für den Verlauf eines Gradienten,

FIG 3     den entsprechenden Verlauf des durch Wirbelströme verursachten Feldfehlers $B_F$,

FIG 4     den Verlauf eines periodisch geschalteten Gradienten G mit dem Ein-/Ausschaltverhältnis a:b,

FIG 5     den entsprechenden Verlauf des durch Wirbelströme verursachten Feldfehlers $B_F$,

FIG 6     den zeitlichen Verlauf eines Gradienten G bei Scans mit zeitvariablen Pausen,

FIG 7     den entsprechenden Verlauf des durch Wirbelströme verursachten Feldfehlers $B_F$,

FIG 8     den zeitlichen Verlauf eines Gradienten G mit in die Pausen eingefügten zusätzlichen Gradientenpulsen $G'$ entsprechend der Erfindung und

FIG 9     den entsprechenden Verlauf des durch Wirbelströme verursachten Feldfehlers $B_F$.

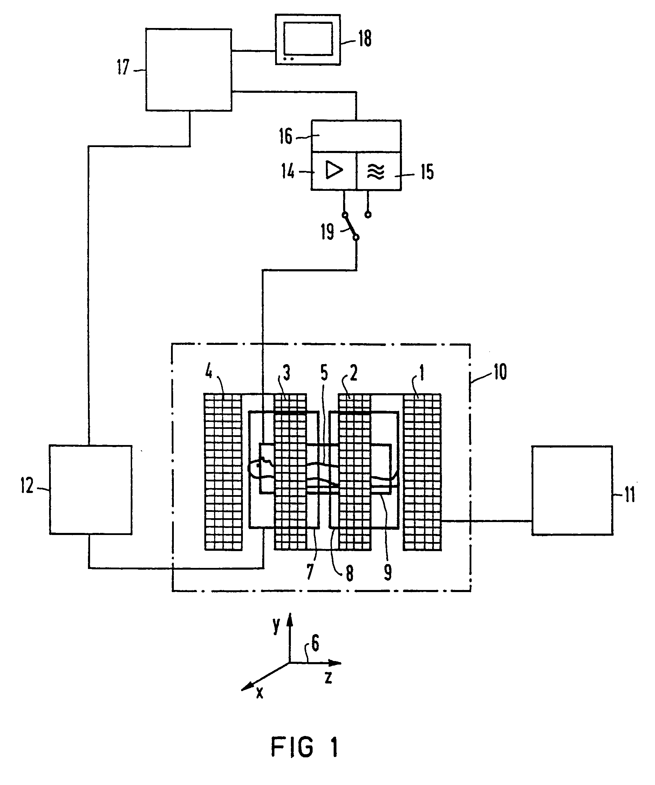

FIG 1 zeigt schematisch den prinzipiellen Aufbau eines Kernspin-Tomographiegerätesfür die Erstellung von Bildern eines Untersuchungsobjektes. Die Spulen 1 bis 4 erzeugen ein magnetisches Grundfeld $B_O$, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß dem Koordinatenkreuz 6 vorgesehen sind. In der Figur sind der Übersichtlichkeit halber nur die Gradientenspulen 7 und 8 gezeichnet, die zusammen mit einem Paar gegenüberliegender, gleichartiger Gradientenspulen zur Erzeugung eines x-Gradienten dienen. Die gleichartigen, nicht gezeichneten y-Gradientenspulen liegen parallel zum Körper 5 und oberhalb sowie unterhalb von ihm, die für das z-Gradientenfeld quer zu seiner Längsachse am Kopf- und am Fußende.

Die Anordnung enthält außerdem noch eine zur Erzeugung und Aufnahme der Kernresonanzsignale dienende Hochfrequenzspule 9. Die von einer strichpunktierten Linie 10 umgrenzten Spulen 1, 2, 3, 4, 7, 8 und 9 stellen das eigentliche Untersuchungsinstrument dar.

Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Hochfrequenzspule 9 ist über einen Signalverstärker 14 bzw. einen Hochfrequenzsender 15 an einen Prozeßrechner 17 gekoppelt, an dem zur Ausgabe der Abbildung ein Bildschirmgerät 18 angeschlossen ist. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

Ein Bild des Untersuchungsobjektes wird dadurch erzeugt, daß durch Einstrahlung eines Hochfrequenzpulses über die Hochfrequenzspule 9 Kernspins angeregt werden und ebenfalls über die Hochfrequenzspule 9 die entstehenden Kernresonanzsignale empfangen werden. Durch Aufschaltung von Gradientenfeldern wird dabei eine räumliche Selektion der Signale erreicht. Durch eine mehrdimensionale Fourier-Rekonstruktion wird aus diesen Signalen ein Bild erzeugt. Da es bei der im folgenden beispielhaft beschriebenen Erfindung nicht auf die Pulssequenz ankommt, wird hierauf nicht näher eingegangen.

Für Pulssequenzen gibt es eine Vielzahl von Möglichkeiten, lediglich beispielhaft sei hierzu auf die bereits genannte EP-A2-0 117 725 verwiesen.

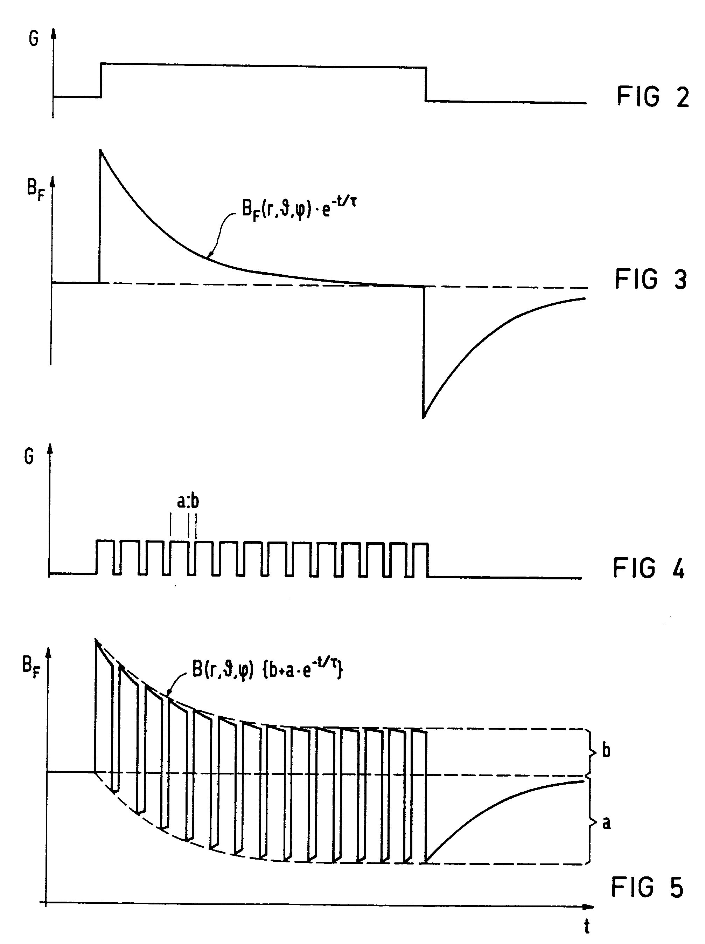

Zur Erläuterung der Problemstellung ist in FIG 2 ein einzelner Gradientenpuls G und in FIG 3 der zugehörige, durch Wirbelströme verursachte Feldfehler $B_F$ dargestellt. Bekanntlich induzieren die durch den Pulsbetrieb der Gradientenspule ausgelösten Flußänderungen in allen elektrisch leitfähigen Teilen Ströme, die so gerichtet sind, daß ihr Eigenfeld dem eindringenden Fluß entgegenwirkt. Als elektrisch leitfähige Teile kommen bei Kernspin-Tomographen hauptsächlich die metallischen Wände des Kryostaten, aber auch alle metallischen Bauteile der Hochfrequenzresonatoren in Betracht. Die Bauformen und Positionen dieser Komponenten bedingen, daß die induzierten Wirbelströme keine idealen Spiegelströme, sondern ein diffus verbreitertes und projiziertes Abbild der primären Ströme in den Gradientenspulen sind. Die räumlichen Feldverteilungen infolge des primären Stroms und des Wirbelstroms sind somit nicht identisch. Nur der beiden Strömen gemeinsame Feldanteil kann durch entsprechend modifizierte Erregung der Gradientenspulen auf jede gewünschte Zeitabhängigkeit eingestellt werden. Dieser Vorgang wird üblicherweise als "Wirbelstromkompensation" bezeichnet.

Es verbleiben somit alle übrigen Feldanteile, die mit materialspezifischen Zeitkonstanten wie die ursächlichen Wirbelströme abklingen. Diese zeitvariablen Feldanteile werden im weiteren als dynamische Feldfehler $B_F$ bezeichnet.

Im Pulsbetrieb der Gradientenspulen werden Feldfehler erzeugt, die weder räumlich noch zeitlich konstant sind und damit die Qualität der MR-Bilder beeinträchtigen können.

Wie FIG 3 zeigt, werden die Wirbelströme mit jeder Flanke des Gradientenpulses G erzeugt und klingen exponentiell ab, so daß auch der entsprechende Feldfehler $B_F$ exponentiell abklingt. In der Darstellung nach FIG 3 wurde dabei vereinfacht ein Abklingen mit einer einzigen Zeitkonstante angenommen. Die weiteren Ausführungen bleiben aber auch dann gültig, wenn der Abklingvorgang des Feldfehlers $B_F$ bei Anwesenheit mehrerer unterschiedlicher Zeitkonstanten erfolgt.

Ein wiederholtes Erregen der Gradientenspulen in einer Zeit, die klein oder vergleichbar zur Wirbel-stromzeitkonstante $\tau$ ist, führt zu einer Überlagerung der von den einzelnen Schaltvorgängen ausgelösten Feldfehler $B_F$. Wird der zum Zeitpunkt $t_i$ durch das Schalten eines Gradientenstroms erzeugte Feldfehler mit $B_i$ $(r,\vartheta,\phi)$ bezeichnet, so beträgt der Gesamtfehler zum Zeitpunkt t $(t > t_i)$:

$$B(r, \vartheta, \phi, t) = \sum_{i=1}^{N} B_i(r, \vartheta, \phi) e^{-(t - t_i)/\tau}$$

wobei $r,\vartheta,\phi$ Kugelkoordinaten sind.

Ein Beispiel hierzu ist in den FIG 4 und 5 dargestellt. Gemäß FIG 4 wird eine Gradientenspule mit Pulsen konstanter Amplitude im Ein-/Ausschaltverhältnis a:b erregt. Der entsprechende Verlauf des normierten Feldfehlers $B_F$ ist in FIG 5 dargestellt. Nach einem Einschwingvorgang, dessen Dauer durch die Wirbelstromzeitkonstante $\tau$ bestimmt ist, stellt sich ein dynamisches Gleichgewicht der Feldfehler $B_F$ ein, das sich aus dem zeitlichen Mittelwert der applizierten Gradientenstärke ableitet. Nach Beendigung der Pulsfolge geht der Feldfehler $B_F$ von diesem Wert ausgehend wieder gegen Null.

Im folgenden werden nun die Auswirkungen auf die Qualität der MR-Bilder behandelt. Der Bildgebungsvorgang besteht standardmäßig aus dem seriellen Messen der zum Bildaufbau benötigten Fourier-Projektionen. Der Meßablauf für eine Fourier-Projektion wird als Scan bezeichnet, so daß die Gesamtmessung aus der seriellen Abfolge der Scans besteht. Während eines Scans werden die Gradienten mehrfach geschaltet, wie in FIG 4 dargestellt. Wenn die Scans streng periodisch appliziert werden, d.h. die Repetitionszeit $T_R$ der Scans konstant ist, so stellen sich von Scan zu Scan die gleichen Feldfehler ein. Wegen der Gleichartigkeit kommt es dabei in der Regel zu keinen auffälligen Bildstörungen. Wenn z.B. die Wirbelstromzeitkonstanten lang gegenüber der Zeit eines Scans sind, so führen die Feldfehler $B_F$ lediglich zu geometrischen Verzeichnungen, wie sie auch durch statische Feldinhomogenitäten verursacht werden.

Mit der vorliegenden Erfindung sollen die besonderen Probleme, die bei nicht periodischer Abfolge der Scans, d.h. bei nicht konstanter Repetitionszeit $T_R$ auftreten, gelöst werden. Diese Situation liegt z.B. immer bei bewegungsabhängig getriggerter Bildgebung, also z.B. bei EKG-Triggerung vor. Jeder Scan wird dann durch das EKG des Patienten ausgelöst, so daß die Repetitionszeiten von der Herzaktivität abhängen und damit nicht mehr konstant sind.

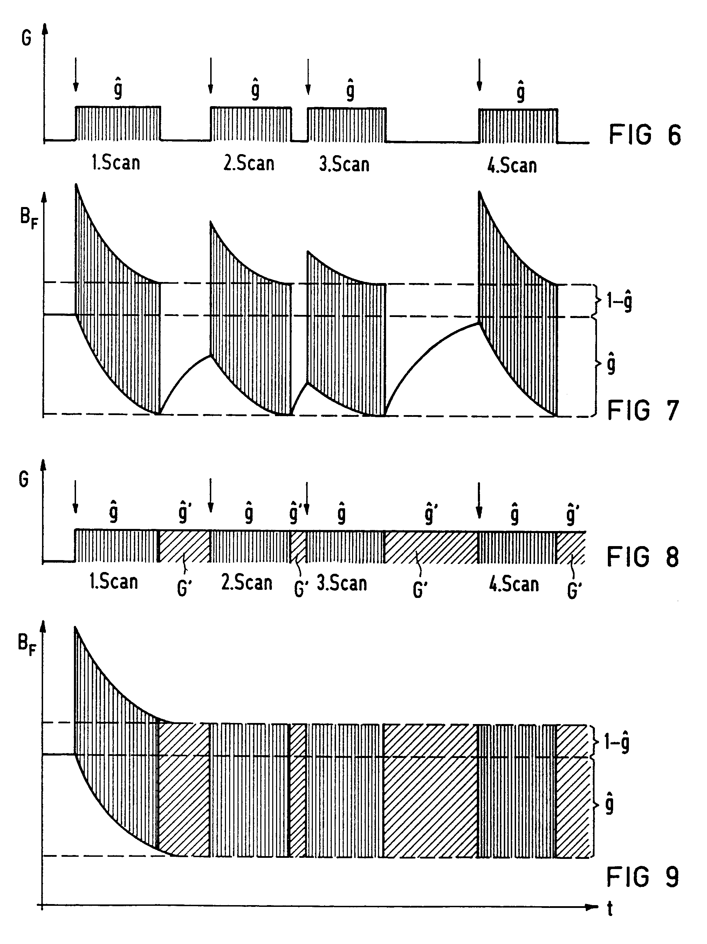

Diese Situation ist in FIG 6 dargestellt. Dabei sind die Pulse innerhalb eines Scans nicht mehr einzeln aufgelöst, sondern in Form ihrer Einhüllenden dargestellt. Entscheidend ist der mit $\hat{g}$ bezeichnete zeitliche Mittelwert der Gradientenstärke während eines einzelnen Scans S. Er bestimmt den Gleichgewichtszustand, dem die Feldfehler $B_F$, von unterschiedlichen Startsituationen bei Scanbeginn ausgehend, zustreben.

Wie FIG 7 zeigt, sind als Folge der unterschiedlichen Zeitabstände zwischen den einzelnen Scans jetzt die Feldfehler $B_F$ von Scan zu Scan unterschiedlich. FIG 7 zeigt wiederum nur die Einhüllende der normierten Feldfehler $B_F$. Dabei sieht man, daß die Feldfehler $B_F$ bei gegebener Wirbelstromzeitkonstante von der Repetitionszeit abhängen, wobei die Feldfehler $B_F$ umso unterschiedlicher werden, je kürzer die Repetitionszeit ist. Erst wenn die Repetitionszeit deutlich länger als die Wirbelstromzeitkonstante wird, werden die Unterschiede der Feldfehler $B_F$ vernachlässigbar klein.

Je nach verwendetem Bildgebungsverfahren und Rekonstruktionsalgorithmus führt die Unterschiedlichkeit der Feldfehler $B_F$ während der einzelnen Scans zu teilweise erheblichen Bildstörungen. Bei zweidimensionalen und dreidimensionalen Fourier-Rekonstruktionsverfahren ergeben sich beispielsweise wegen der Empfindlichkeit der Fourier-Transformation gegen Phasenfehler signifikante Artefakte in Richtung der phasencodierten Bildachsen.

Der Grundgedanke der Erfindung besteht nun darin, trotz variierender Repetitionszeit $T_R$ den Beitrag der Feldfehler $B_F$ von Scan zu Scan konstant zu halten, wie es bei streng periodischer Abfolge der Scans der Fall wäre.

Dies gelingt dadurch, daß zusätzlich zu den für die Bildgebung notwendigen Gradientenpulsen während der Scans weitere Gradientenpulse $G'$ während der zeitvariablen Pausen zwischen den Scans zugeschaltet werden. Dabei ist es wesentlich, daß der zeitliche Mittelwert $\hat{g}$ der Gradientenstärke während der konstanten Scanzeit und der Mittelwert $\hat{g}'$ der Gradientenstärke während der variablen Pausenzeit stets gleich ist. Dies ist z.B. dann der Fall, wenn der Gradient G in den Pausen mit konstanter Mittelwertamplitude $\hat{g}'$ eingeschaltet wird.

FIG 9 zeigt den Verlauf des sich dabei ergebenden normierten Feldfehlers $B_F$. Die schraffierten Bereiche kennzeichnen die Abschnitte der zusätzlichen Gradientenpulse $G'$, die sicherstellen, daß die nach einem einmaligen Einschwingvorgang jetzt stets gleichbleibenden Feldfehler $B_F$ während der gesamten Messung keine Scan-abhängigen Störungen auslösen. Die erwähnten, durch unterschiedliche Feldfehler von Scan zu Scan verursachten Bildartefakte werden damit vermieden.

## Patentansprüche

1. Pulssequenz für ein Kernspin-Tomographiegerät mit Spulen (1-4, 7, 8) zum Anlegen von magnetischen Grund- und Gradientenfeldern an ein Untersuchungsobjekt (5) und mit einer Hochfrequenzeinrichtung (9, 16), die das Untersuchungsobjekt (5) mit einer Folge von Hochfrequenzimpulsen bestrahlt und die vom Untersuchungsobjekt (5) ausgesandten Kernresonanzsignale erfaßt, wobei während eines Scans Gradientenfelder (G) wiederholt eingeschaltet werden und wobei die Repetitionszeit $T_R$ der Scans nicht konstant ist, **dadurch gekennzeichnet,** daß in der Zeit zwischen zwei aufeinanderfolgenden Scans Gradientenpulse (G') mit einem zeitlichen Mittelwert $(\hat{g}')$ geschaltet werden, der gleich dem zeitlichen Mittelwert $(\hat{g})$ der entsprechenden Gradienten (G) während jedes Scans ist.

2. Pulssequenz nach Anspruch 1, **dadurch gekennzeichnet,** daß jeder Scan durch eine von Bewegungen des Untersuchungsobjekts abhängige Triggerung ausgelöst wird.

3. Pulssequenz nach Anspruch 1 oder 2, **dadurch gekennzeichnet,** daß die Gradientenpulse (G') zwischen zwei aufeinanderfolgenden Scans als Dauerimpulse geschaltet werden.

4. Pulssequenz nach Anspruch 1 oder 2, **dadurch gekennzeichnet,** daß die Gradientenpulse (G') zwischen zwei aufeinanderfolgenden Scans als Folge einzelner Pulse geschaltet werden.

## Claims

1. Pulse sequence for a nuclear spin tomography device having coils (1-4, 7, 8) for the application of magnetic base and gradient fields to an object to be examined (5) and having a high-frequency device (9, 16), which irradiates the object to be examined (5) with a series of high-frequency pulses and detects the nuclear resonance signals emitted by the object to be examined (5), wherein, during a scan, gradient fields (G) are repeatedly switched on and wherein the repetition time $T_R$ of the scans is not constant, characterized in that, in the time between two successive scans, gradient pulses (G') with a temporal mean value ($\hat{g}$ ') are connected, which mean value ($\hat{g}$ ') is the same as the temporal mean value ($\hat{g}$) of the corresponding gradients (G) during each scan.

2. Pulse sequence according to claim 1, characterized in that each scan is initiated by a triggering which is dependent on movements of the object to be examined.

3. Pulse sequence according to claim 1 or 2, characterized in that the gradient pulses (G') are connected between two successive scans as continuous pulses.

4. Pulse sequence according to claim 1 or 2, characterized in that the gradient pulses (G') are connected between two successive scans as series of individual pulses.

**Revendications**

1. Séquence d'impulsions pour un appareil de tomographie à résonance magnétique nucléaire comportant des bobines (1-4,7,8) servant à appliquer un champ magnétique de base et des champs magnétiques irrotationnels à un objet d'examen (5), et un dispositif à haute fréquence (9,16), qui irradie l'objet d'examen (5) avec uie suite d'impulsions à haute fréquence et détecte les signaux de résonance nucléaire émis par l'objet d'examen (5), les champs irrotationnels (G) étant appliqués d'une manière répétée pendant un balayage, avec un temps de répétition $T_R$ du balayage non constant, caractérisé par le fait que pendant l'intervalle de temps s'étendant entre deux balayages successifs, on applique des impulsions de gradient (G') possédant une valeur moyenne dans le temps (g'), qui est égale à la valeur moyenne dans le temps (g) des gradients (G) correspondants pendant chaque balayage.

2. Séquence d'impulsions suivant la revendication 1, caractérisée par le fait que chaque balayage est initié par un déclenchement qui dépend de déplacements de l'objet d'examen.

3. Séquence d'impulsions suivant la revendication 1 ou 2, caractérisée par le fait que les impulsions de gradients (G') sont appliquées en tant qu'impulsions continues entre deux balayages successifs.

4. Séquence d'impulsions suivant la revendication 1 ou 2, caractérisée par le fait que les impulsions de gradient (G') sont appliquées sous la forme d'une suite d'impulsions individuelles entre deux balayages successifs.

FIG 1

G

FIG 2

$B_F$

$B_F(r,\vartheta,\varphi)\cdot e^{-t/\tau}$

FIG 3

G

a:b

FIG 4

$B_F$

$B(r,\vartheta,\varphi)\ \{b+a\cdot e^{-t/\tau}\}$

b

a

FIG 5

t

FIG 6

FIG 7

FIG 8

FIG 9